# FASCICULE DE BREVET EUROPEEN

(11) **EP 0 400 335 B1**
(45) Date de publication et mention de la délivrance du brevet: **05.01.1994**
(21) Numéro de dépôt: 90108119.0
(22) Date de dépôt: 27.04.1990
(51) Int. Cl.: H05K 7/20, B60H 1/32

(54) **Procédé de refroidissement de composants électriques, dispositif pour la mise en oeuvre de ce procédé et application aux composants embarqués dans un véhicule**
Verfahren zur Kühlung von elektronischen Bausteinen, Vorrichtung zur Durchführung dieses Verfahrens und Verwendung bei Bausteinen für Kraftfahrzeuge
Cooling process for electronic components, device for carrying out this process and use for vehicle components

(30) Priorité: 27.04.1989 FR 8905603
(43) Date de publication de la demande: 05.12.1990
(73) Titulaire: GEC ALSTHOM SA, 75116 Paris (FR)
(72) Inventeur: Periot, Robert, F-01600 Trevoux (FR)
(74) Mandataire: Weinmiller, Jürgen

(56) Documents cités:
- EP-A- 0 047 655
- EP-A- 0 184 146
- DE-A- 3 704 182
- FR-A- 2 580 060
- US-A- 3 989 099
- US-A- 4 546 619

## Description

La présente invention concerne un procédé de refroidissement de composants électriques, un dispositif pour la mise en oeuvre de ce procédé et une application aux composants embarqués dans un véhicule.

Des composants électriques, notamment des composants électroniques tels que diodes, transistors, triacs, thyristors, résistances, sont employés dans des équipements qui véhiculent des puissances importantes. Ces composants sont généralement fixés sur un bloc support. De tels équipements, même s'ils travaillent avec un bon rendement, transforment une partie de l'énergie électrique qui leur est fournie en énergie thermique qu'il convient d'évacuer pour maintenir une température des composants compatibles avec leurs fonctionnements.

On connaît plusieurs systèmes qui dans certains cas, permettent effectivement de refroidir de tels composants :
- échangeurs directs passifs (radiateurs),
- circulation de fluide caloporteur avec ou sans changement de phase,
- caloducs.

De tels systèmes ont été décrits, notamment dans les documents EP-A-0184146, US-A-3989099, EP-A-0047655. Les systèmes sont essentiellement passifs, c'est-à-dire que la température diminue régulièrement de la source chaude, le composant en l'occurrence, à la source froide ou milieu extérieur d'échange thermique (souvent un radiateur). si ce milieu extérieur a une température largement variable ou, si, a fortiori il a une température plus élevée que celle à laquelle les composants électriques peuvent fonctionner, de tels systèmes ne donnent pas satisfaction.

On connaît également des systèmes incorporant une boucle frigorifique pourvue d'un évaporateur et d'un condenseur. Ainsi, la demande de brevet FR-A-2 580 060 décrit un dispositif de refroidissement de systèmes électroniques comprenant plusieurs ensembles de refroidissement, le condenseur de chaque ensemble étant fixé sur un radiateur qui est refroidi par l'air ambiant au moyen d'un ventilateur. La puissance de réfrigération de chaque ensemble dépend, là aussi, directement de la température de l'air ambiant ; il s'ensuit que les dimensionnement du radiateur et du ventilateur doivent être prévus en conséquence.

On connaît par ailleurs les systèmes de climatisation de véhicules automobiles décrits, notamment, dans la demande de brevet DE-A-3 704 182. De tels systèmes sont effectivement prévus pour assurer une température constante dans l'habitacle quelle que soit la température extérieure. Ils incorporent également un radiateur et un ventilateur qui sont dimensionnés pour des conditions extérieures définies.

La présente invention a ainsi pour objet un procédé et un dispositif de refroidissement de composants électriques embarqués dans un véhicule automobile dont la puissance de réfrigération ne dépend pas de la température extérieure, ce dispositif ne nécessitant pas de ventilateur et incorporant des moyens de refroidissement du condenseur de dimensions réduites.

Le procédé de refroidissement de composants électriques, notamment de composants électroniques de la présente invention telle que definie dans la revendication 1 comprenant les opérations suivantes :
- transfert des calories produites par ces composants de manière directe ou indirecte au fluide frigorigène d'une boucle frigorifique au moyen d'un premier échangeur thermique pourvu d'un évaporateur,
- transfert des calories précédemment cédées à ce fluide frigorigène à un milieu extérieur au moyen d'un deuxième échangeur pourvu d'un condenseur en contact avec le milieu extérieur, se caractérise en ce que le milieu extérieur est le liquide de refroidissement d'un moteur à combustion interne.

Dans un mode particulier de réalisation de l'invention, le procédé de refroidissement de composants électriques, notamment de composants électroniques comprend les opérations suivantes :
- transfert des calories produites par ces composants électriques au fluide caloporteur d'un circuit secondaire pourvu d'une pompe de circulation, au moyen d'un échangeur intermédiaire,
- transfert des calories du fluide caloporteur du circuit secondaire au fluide frigorigène de la boucle frigorifique par l'intermédiaire du premier échangeur,
- transfert des calories du fluide frigorigène de cette boucle frigorifique au milieu extérieur.

Dans un autre mode particulier de réalisation de l'invention, le procédé de refroidissement de composants électriques, notamment de composants électroniques comprend les opérations suivantes :
- transfert des calories produites par ces composants électriques directement au fluide frigorigène de la boucle frigorifique par l'intermédiaire du bloc support,
- transfert des calories précédemment cédées à ce fluide frigorigène au milieu extérieur.

L'invention a également pour objet un dispositif tel que defini dans la revendication 4 pour la mise en oeuvre des diverses variantes du procédé de l'invention.

L'invention s'applique en particulier au refroidissement de composants électriques qui sont embarqués dans un véhicule automobile.

Les différents objets et caractéristiques de l'invention seront maintenant exposés de façon plus détaillée dans la description d'exemples de réalisation donnés à titre non limitatif en se référant au dessin annexé dans lequel:
- la figure 1 est un diagramme d'une machine frigorifique de type connu,
- la figure 2 est un schéma d'un dispositif de refroidissement de composants électriques selon l'invention,
- la figure 3 est un schéma d'un autre dispositif de refroidissement de composants électriques selon l'invention,
- la figure 4 est un schéma d'un troisième dispositif de refroidissement de composants électriques selon l'invention.

Les éléments communs aux différentes figures ont reçu les mêmes références.

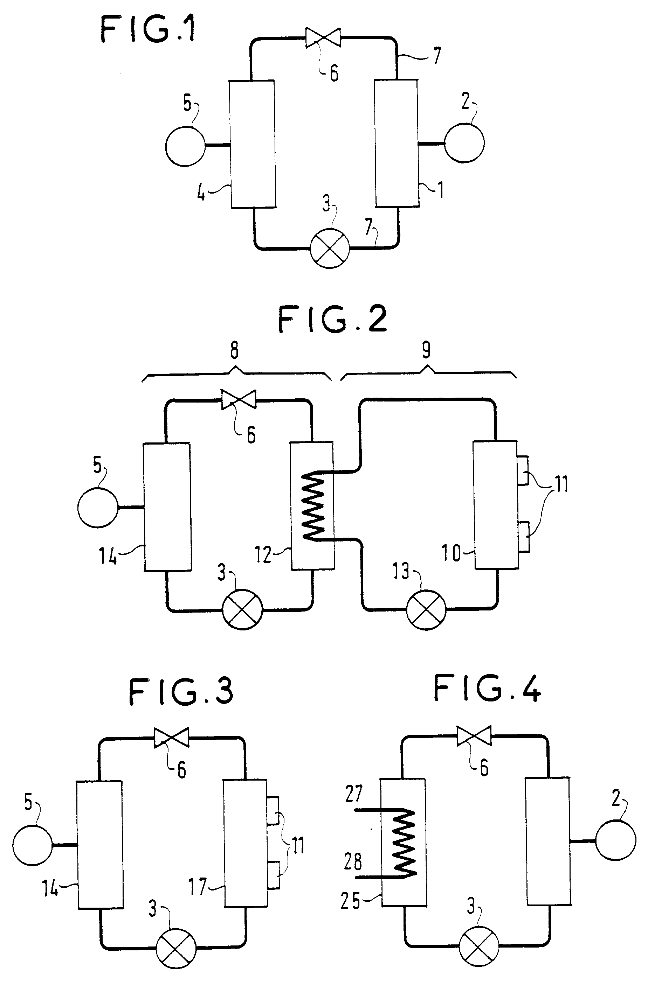

On rappellera brièvement le fonctionnement d'une machine frigorifique connue schématisée dans la figure 1 et décrite notamment dans l'ouvrage "Réfrigération Industrielle de M.Conan-Eyrolles" qui peut être utilisée dans le cadre de l'invention, étant entendu que tout autre machine assurant la même fonction peut également convenir. Cette machine est constituée d'un évaporateur 1 en contact thermique direct ou indirect avec l'élément 2 à refroidir, d'un compresseur 3, d'un condenseur 4 en contact thermique avec un milieu extérieur 5 pour lui céder des calories, d'un détendeur 6, tous ces sous-ensembles étant réunis par des canalisations 7 où circule un fluide frigorigène. Le cycle de fonctionnement d'une telle machine à compression de vapeur est le suivant :
- évaporation du fluide dans un premier échangeur thermique 1 à température T1 par acquisition de calories en provenance de l'élément 2 à refroidir,
- compression de cette vapeur entraînant son échauffement à une température T2
- refroidissement et condensation de cette vapeur dans un deuxième échangeur thermique 4 en cédant des calories au milieu extérieur 5,
- sous-refroidissement en phase liquide à la température T3,
- détente de ce liquide grâce au détendeur 6 avec refroidissement et retour à l'évaporateur 1.

Dans le cadre de l'invention, T1 est la température de fonctionnement des composants électriques qui est inférieure à T3 température que l'on peut assimiler à celle de ce que l'on est convenu d'appeler le milieu extérieur, T3 étant inférieure à T2.

On décrira maintenant plus spécifiquement le procédé de refroidissement de composants électriques selon l'invention. Il est bien évident que la présente description concerne également les dispositifs permettant de mettre en oeuvre le procédé selon l'invention.

Dans la présente invention, le procédé de refroidissement de composants électriques fait appel à un cycle thermodynamique tel que celui de la machine frigorifique décrite ci-dessus. Une opération commune aux différentes variantes consiste à refroidir un élément 2 qui est, soit un fluide caloporteur transportant des calories générées par ces composants électriques, soit ces composants électriques eux-mêmes où leurs blocs supports.

Dans une première forme de l'invention représentée dans la figure 2, le procédé de refroidissement fait appel à deux boucles thermiques : une boucle frigorifique 8 et un circuit secondaire 9.

Le procédé comprend, notamment, les opérations suivantes :
- transfert des calories des composants électriques 11 ou de leurs blocs supports au fluide du circuit secondaire 9 au sein de l'échangeur 10,
- circulation du fluide du circuit secondaire 9 avec la pompe de circulation 13,
- transfert des calories du fluide du circuit secondaire 9 au fluide frigorigène de la boucle frigorifique 8 au sein d'un échangeur 12 commun aux deux boucles thermiques, échangeur qui comprend l'évaporateur de cette boucle frigorifique,
- transfert des calories du fluide frigorigène de la boucle frigorifique 8 au milieu extérieur 5 au sein de l'échangeur 14 qui comprend le condenseur de cette boucle frigorifique.

Ce procédé permet bien de refroidir les composants électriques ou leurs blocs supports en cédant les calories qu'ils génèrent à un milieu extérieur d'une température plus élevée.

Dans une autre forme de l'invention représentée dans la figure 3, le procédé de refroidissement fait appel à une seule boucle thermique qui est une boucle frigorifique. Il comprend notamment les opérations suivantes :
- transfert des calories des composants électriques 11 ou de leurs blocs supports avec le fluide calorigène de la boucle frigorifique au sein de l'échangeur 17 qui constitue l'évaporateur de cette boucle frigorifique,
- transfert des calories du fluide frigorigène de la boucle frigorifique au milieu extérieur 21 au sein de l'échangeur 14 qui comprend le condenseur de cette boucle frigorifique.

L'avantage de cette variante réside dans l'utilisation d'une seule boucle thermique. Le dispositif correspondant est donc plus simple a mettre en oeuvre car il comprend moins d'éléments.

Dans une troisième forme de l'invention représentée dans la figure 4, les considérations précédentes s'appliquent. De plus, le transfert des calories du fluide frigorigène de la boucle frigorifique s'effectue au sein d'un échangeur 25 où le milieu extérieur est le liquide de refroidissement d'un moteur à combustion interne qui circule au sein de cet échangeur grâce à deux accès 27, 28.

Pour prendre un exemple concret, les composants électriques fonctionnent à une température de l'ordre de 50°C alors que le liquide de refroidissement peut voir sa température monter jusqu'à 100, 110°C.

L'invention, dans une forme d'application du procédé permet, en faisant appel notamment à un cycle frigorifique, le refroidissement de composants électroniques embarqués dans un véhicule automobile.

## Revendications

1. Procédé de refroidissement de composants électriques, notamment de composants électroniques, comprenant les opérations suivantes :
- transfert des calories produites par lesdits composants (2) de manière directe ou indirecte au fluide frigorigène d'une boucle frigorifique (8) au moyen d'un premier échangeur thermique (1, 12) pourvu d'un évaporateur,
- transfert des calories précédemment cédées audit fluide frigorigène à un milieu extérieur (5) au moyen d'un deuxième échangeur (4, 14, 25) pourvu d'un condenseur en contact avec ledit milieu extérieur, caractérisé en ce que ledit milieu extérieur est le liquide de refroidissement d'un moteur à combustion interne.

2. Procédé de refroidissement de composants électriques, notamment de composants électroniques, selon la revendication 1, caractérisé en ce qu'il comprend les opérations suivantes :
- transfert des calories produites par lesdits composants électriques (11) au fluide caloporteur d'un circuit secondaire (9) pourvu d'une pompe de circulation (13), au moyen d'un échangeur intermédiaire (10),
- transfert des calories du fluide caloporteur dudit circuit secondaire au fluide frigorigène de ladite boucle frigorifique (8) par l'intermédiaire dudit premier échangeur,
- transfert des calories du fluide frigorigène de ladite boucle frigorifique audit milieu extérieur (5).

3. Procédé de refroidissement de composants électriques, notamment de composants électroniques, selon la revendication 1, caractérisé en ce qu'il comprend les opérations suivantes :
- transfert des calories produites par lesdits composants électriques (11) directement au fluide frigorigène de ladite boucle frigorifique (8) par l'intermédiaire du bloc support,
- transfert des calories précédemment cédées audit fluide frigorigène audit milieu extérieur (5).

4. Dispositif de refroidissement de composants électriques (11) notamment de composants électroniques, comprenant une boucle frigorifique (8) pourvue
- d'un premier échangeur thermique (1, 12) incorporant un évaporateur recevant des calories générées par lesdits composants,
- d'un deuxième échangeur thermique (14) incorporant un condenseur en contact thermique avec un milieu extérieur (5),
caractérisé en ce que ledit milieu extérieur est le liquide de refroidissement d'un moteur à combustion interne.

5. Dispositif de refroidissement de composants électriques, notamment de composants électroniques, selon la revendication 4, caractérisé en ce qu'il comprend notamment les moyens suivants :
- un premier échangeur intermédiaire (10) qui transfère les calories provenant desdits composants électriques (11) ou de leur support au fluide caloporteur d'un circuit secondaire (9),
- ledit premier échangeur thermique (12) transfèrant les calories du fluide caloporteur dudit circuit secondaire au fluide frigorigène de ladite boucle frigorifique (8).

6. Dispositif de refroidissement selon la revendication 4, caractérisé en ce que lesdits composants (11) sont fixés sur ledit premier échangeur thermique (1, 12).

7. Application du dispositif selon l'une quelconque des revendications 4 à 6, caractérisée en ce que lesdits composants électriques sont embarqués dans un véhicule automobile.

## Claims

1. Method of cooling electrical components, especially electronic components, comprising the following operations:
- transferring heat energy produced by said components (2) directly or indirectly to the cooling fluid of a cooling loop (8) by means of a first heat exchanger (1, 12) provided with an evaporator,
- transferring heat energy previously transferred to said cooling fluid to an outside environment (5) by means of a second heat exchanger (4, 14, 25) provided with a condenser in contact with said outside environment, characterised in that said outside environment is the cooling liquid of an internal combustion engine.

2. Method of cooling electrical components, especially electronic components, according to claim 1, characterised in that it comprises the following operations:
- transferring heat energy produced by said electrical components (11) to the cooling fluid of a secondary circuit (9) provided with a circulation pump (13) by means of an intermediate heat exchanger (10),
- transferring heat energy from the cooling fluid of said secondary circuit to the cooling fluid of said cooling loop (8) by means of said first exchanger,
- transferring heat energy from the cooling fluid of said cooling loop to said outside environment (5).

3. Method of cooling electrical components, especially electronic components, according to claim 1, characterised in that it comprises the following operations:
- transferring heat energy produced by said electrical components (11) directly to the cooling fluid of said cooling loop (8) by means of the support assembly,
- transferring heat energy previously transferred to said cooling fluid to said outside environment (5).

4. Device for cooling electrical components (11) especially electronic components, comprising a cooling loop (8) provided with
- a first heat exchanger (1, 12) incorporating an evaporator receiving heat energy generated by said components,
- a second heat exchanger (14) incorporating a condenser in thermal contact with an outside medium (5),
- characterised in that said outside medium is the cooling liquid of an internal combustion engine.

5. Device for cooling electrical components, especially electronic components, according to claim 4, characterised in that it includes the following means:
- a first intermediate heat exchanger (10) which transfers heat energy from said electrical components (11) or their support to the cooling fluid of a secondary circuit (9),
- said first heat exchanger (12) transferring heat energy from the cooling fluid of said secondary circuit to the cooling fluid of said cooling loop (8).

6. Cooling device according to claim 4 characterised in that said components (11) are fixed to said first heat exchanger (1, 12).

7. Application of the device according to any one of claims 4 to 6 characterised in that said electrical components are on board an automobile vehicle.

## Patentansprüche

1. Verfahren zum Kühlen elektrischer Bauelemente, insbesondere elektronischer Bauelemente, das folgende Schritte umfaßt:
- Übertragen der von den Bauelementen (2) erzeugten Kalorien in direkter oder indirekter Weise auf das kälteerzeugendes Fluid einer Kühlschleife (8) mit Hilfe eines ersten Wärmetauschers (1, 12), der mit einem Verdampfer versehen ist,
- Übertragen der vorher an das kälteerzeugende Fluid abgegebenen Kalorien an ein äußeres Milieu (5) mit Hilfe eines zweiten Wärmetauschers (4, 14, 25), der mit einem Kondensator versehen ist, welcher mit dem äußeren Milieu in Wärmekontakt steht,
dadurch gekennzeichnet, daß das äußere Milieu die Kühlflüssigkeit eines Verbrennungsmotors ist.

2. Verfahren zum Kühlen elektrischer Bauelemente, insbesondere elektronischer Bauelemente, gemäß Anspruch 1, dadurch gekennzeichnet, daß es folgende Schritte enthält:
- Übertragen der von den elektrischen Bauelementen (11) erzeugten Kalorien an ein Wärmeträgerfluid eines mit einer Umwälzpumpe (13) versehenen Sekundärkreises (9) mit Hilfe eines Zwischenwärmetauschers (10),
- Übertragen der Kalorien des Wärmeträgerfluids des Sekundärkreises an das kälteerzeugende Fluid der Kühlschleife (8) über den ersten Wärmetauscher,
- Übertragen der Kalorien des kälteerzeugenden Fluids der Kühlschleife an das äußere Milieu (5).

3. Verfahren zum Kühlen elektrischer Bauelemente, insbesondere elektronischer Bauelemente, nach Anspruch 1, dadurch gekennzeichnet, daß es die folgenden Schritte enthält:
- Übertragen der von den elektrischen Bauelementen (11) erzeugten Kalorien direkt an das kälteerzeugende Fluid der Kühlschleife (8) über den Trägerblock,
- Übertragen der vorher an das kälteerzeugende Fluid abgegebenen Kalorien an das äußere Milieu (5).

4. Einrichtung zum Kühlen elektrischer Bauelemente (11), insbesondere elektronischer Bauelemente, die eine Kühlschleife (8) aufweist, welche versehen ist mit:
- einem ersten Wärmetauscher (1, 12), der einen Verdampfer enthält, welcher von den Bauelementen erzeugte Kalorien aufnimmt,
- einen zweiten Wärmetauscher (14), der einen Kondensator enthält, welcher in Wärmekontakt mit einem äußeren Milieu (5) steht,
dadurch gekennzeichnet, daß das äußere Milieu die Kühlflüssigkeit eines Verbrennungsmotors ist.

5. Einrichtung zum Kühlen elektrischer Bauelemente, insbesondere elektronischer Bauelemente, nach Anspruch 4, dadurch gekennzeichnet, daß sie insbesondere folgende Mittel aufweist:
- einen ersten Zwischenwärmetauscher (10), der die von den elektrischen Bauelementen (11) oder ihrem Träger gelieferten Kalorien an das Wärmefluid eines Sekundärkreises (9) überträgt,
- wobei der erste Wärmetauscher (12) die Kalorien des Wärmeträgerfluids des Sekundärkreises an das kälteerzeugende Fluid der ersten Kühlschleife (8) überträgt.

6. Kühleinrichtung nach Anspruch 4, dadurch gekennzeichnet, daß die Bauelemente (11) auf dem ersten Wärmetauscher (1, 12) befestigt sind.

7. Anwendung der Einrichtung gemäß einem beliebigen der Ansprüche 4 bis 6, dadurch gekennzeichnet, daß die elektrischen Bauelemente in einem Kraftfahrzeug installiert sind.
